Europäisches Patentamt

European Patent Office

Office européen des brevets

(19)

(11) Numéro de publication : **0 345 107 B1**

(12)

# FASCICULE DE BREVET EUROPEEN

(45) Date de publication du fascicule du brevet :
**12.02.92 Bulletin 92/07**

(51) Int. Cl.$^5$ : **B29C 71/04,** C23C 16/02,
C03C 17/34, C09K 3/16

(21) Numéro de dépôt : **89401290.5**

(22) Date de dépôt : **10.05.89**

(54) **Revêtement protecteur multicouche pour substrat, procédé de protection de substrat par dépôt par plasma d'un tel revêtement, revêtements obtenus et leurs applications.**

(30) Priorité : **11.05.88 FR 8806369**

(43) Date de publication de la demande :
**06.12.89 Bulletin 89/49**

(45) Mention de la délivrance du brevet :
**12.02.92 Bulletin 92/07**

(84) Etats contractants désignés :
**AT BE CH DE ES FR GB GR IT LI LU NL SE**

(56) Documents cités :
EP-A- 0 110 258
EP-A- 0 230 788
EP-A- 0 289 402
US-A- 4 645 684
US-A- 4 721 631

(73) Titulaire : **L'AIR LIQUIDE, SOCIETE ANONYME
POUR L'ETUDE ET L'EXPLOITATION DES
PROCEDES GEORGES CLAUDE
75, Quai d'Orsay
F-75321 Paris Cédex 07 (FR)**

(72) Inventeur : **Gauthier, Jean-Marie
39, rue Galliéni
F-91120 Palaiseau (FR)**
Inventeur : **Coeuret, François
63, bd Beethoven Résidence Les Symphonies
F-78280 Guyancourt (FR)**
Inventeur : **Bonet, Claude
3, rue Bargue
F-75015 Paris (FR)**

(74) Mandataire : **Le Moenner, Gabriel et al
L'AIR LIQUIDE, Société Anonyme pour l'étude
et l'exploitation des procédés Georges Claude
75, Quai d'Orsay
F-75321 Paris Cédex 07 (FR)**

**Description**

La présente invention concerne un revêtement protecteur multicouche pour substrat, un procédé de protection de substrat par dépôt par plasma de composés inorganiques, et les revêtements multicouches obtenus par ce procédé.

Dans le domaine de la micro-électronique, il est connu de déposer, à partir de silanes, des composés amorphes du silicium sur du silicium cristallin au sein d'un plasma à des températures supérieures à 200°C.

Dans l'industrie automobile, il est particulièrement intéressant de pouvoir remplacer le verre, notamment pour les glaces des optiques de phares, par des composés polymériques moins lourds et plus adaptés aux formes allongées et arrondies des accessoires automobiles. Il est cependant nécessaire de protéger ces composés polymériques contre les agressions chimiques et mécaniques par un revêtement transparent et de résistance mécanique et thermique convenable. La demande de brevet WO 85/04601 décrit la réalisation d'un tel revêtement en deux étapes, c'est à dire revêtement du substrat à protéger par trempage dans une résine silicone, puis polymérisation à chaud du revêtement.

Pour la fabrication de support d'information pour l'électronique et l'informatique, par exemple les supports magnétiques, il est avantageux de pourvoir le support d'un revêtement essentiellement résistant et antistatique.

La demanderesse a mis en évidence qu'il est possible de réaliser de tels revêtements, transparents, durs, résistants aux variations thermiques et à l'humidité et antistatiques.

C'est pourquoi la présente invention concerne un revêtement multicouche protecteur pour substrat comportant essentiellement du silicium, du carbone, de l'azote, de l'oxygène et de l'hydrogène, constitué d'au moins deux couches, la première couche déposée sur le substrat ayant pour formule $Si\ C_x\ N_y\ O_z\ H_t$, où
$x = 0 - 0,5$ ; $y = 0 - 0,15$ ; $z = 0,4 - 1$ et $t = 0,6 - 1,2$ ; et notamment $z = 0,6 - 0,8$.

La première couche garantit les propriétés d'adhésion et de résistance aux chocs thermiques et à l'humidité du revêtement sur le substrat.

Pour l'obtention des propriétés antistatiques, d'adhérence, de dureté et de résistances aux cycles thermiques, une seconde couche est portée par la première, constituée d'un dépôt de formule
$Si\ C_{x'}\ N_{y'}\ O_{z'}\ O_{z'}\ H_{t'}$ où $x' = 0 - 5$ ; $y' = 0,3 - 0,8$ ; $z' = 1,3 - 2,5$ et $t' = 0,5 - 1,2$ et notamment les couches où $x' = 0,3 - 1$ ; $y' = 0,5 - 0,8$ ; $z' = 1,3 - 2$ et $t' = 0,6 - 1$ sont particulièrement intéressantes.

Ces revêtements sont obtenus par un procédé de dépôt par plasma. C'est pourquoi la présente invention concerne également un procédé de protection de substrat par dépôt d'un revêtement multicouche comportant essentiellement du silicium, du carbone, de l'azote, de l'oxygène et de l'hydrogène, caractérisé en ce qu'il comporte au moins les étapes suivantes :

– on soumet le substrat à un pré-traitement par plasma micro-onde ;
– on expose la surface du substrat prétraité à un plasma micro-onde en présence de précurseur gazeux de silicium pour déposer une première couche ; et
– on soumet le substrat muni de la première couche à un plasma micro-onde en présence des précurseurs gazeux de silicium et d'azote dans le plasma ou en post-décharge pour déposer une seconde couche.

L'invention concerne également les revêtements susceptibles d'être obtenus par le procédé selon l'invention.

Le gaz au sein duquel est créé le plasma est un gaz plasmagène classique, tel que par exemple, les gaz rares de l'air, par exemple l'argon ou l'hélium ou encore le néon, ou l'hydrogène et leurs mélanges.

Cependant il est également possible selon l'invention de créer le plasma avec le gaz précurseur, par exemple avec l'azote, l'ammoniac ou l'oxygène.

Par gaz précurseur d'un élément, on comprend selon l'invention un gaz comportant cet élément et capable de le libérer au sein du plasma. Les différents éléments libérés par les différents précurseurs se recombinent pour former le dépôt inorganique. Les éléments proviennent alors de sources annexes.

On peut choisir le gaz précurseur d'oxygène et/ou d'azote en particulier parmi $O_2$, $N_2O$, $N_2$ et $NH_3$ et comme précurseur de carbone du méthane, de l'éthane ou du $CO_2$. Le précurseur peut être utilisé comme gaz plasmagène, et ainsi dans certains cas l'utilisation de gaz plasmagène classique n'est pas nécessaire.

Les précurseurs du silicium peuvent être les "silanes", c'est-à-dire outre le silane $SiH_4$, les polysilanes tels que $Si_2H_6$ et $Si_3H_8$, les halogénosilanes de formule $Si\ X_n\ H_{4-n}$ où $X = Cl$, $F$ et $n$ est inférieur ou égal à 4 et les organosilanes, par exemple $SiCl_3CH_3$ ou le triéthylsilane.

Mais pour réaliser un revêtement selon l'invention, l'apport en élément précurseur gazeux peut être pour partie d'un autre type, les éléments précurseurs pouvant provenir du substrat lui-même. En effet, les substrats polymériques peuvent générer eux-mêmes sous l'effet du plasma certains éléments constitutifs du revêtement. Un substrat muni de la première couche peut générer également certains éléments constitutifs du revêtement. Il n'est plus alors nécessaire d'introduire sous forme gazeuse que le complément nécessaire à l'obtention des couches du revêtement selon l'invention, par les sources annexes.

La demanderesse a mis en évidence que le ou les précurseurs peuvent être injectés en post-décharge, c'est à dire que le ou les précurseurs sont injectés à l'extrémité aval de la zone visible du jet de plasma, ou dans le plasma.

Il est utile, avant d'effectuer le dépôt, de préparer la surface du substrat en réalisant un pré-traitement sous plasma, ce pré-traitement nettoie la surface du substrat et favorise l'adhésion du dépôt. En particulier, les prétraitements à l'oxygène et à l'ammoniac se sont révélés efficaces pour favoriser l'adhésion du revêtement.

Un post-traitement par plasma peut être avantageux pour la qualité et l'adhérence du dépôt, de même qu'un post-traitement thermique.

Le procédé par plasma micro-onde selon l'invention est mis en oeuvre à basse pression, c'est-à-dire de préférence à moins de 10 torr, et par exemple à une pression de l'ordre de moins de 0,5 torr (1 torr = $1,33.10^2$ Pa). Cette pression est adaptée selon le dispositif de génération du plasma mis en oeuvre.

Les températures à la surface du substrat lors de la mise en oeuvre du procédé selon l'invention, c'est à dire avec un plasma micro-onde basse pression, sont de l'ordre de moins de 100°C, et en particulier inférieures aux températures de dégradation de la surface à traiter, en particulier inférieures à la température de transition vitreuse du substrat quand celui-ci est polymérique ; ceci présente l'avantage que l'on peut traiter des matériaux polymériques sans moyens de refroidissement durant la mise en oeuvre du procédé.

Ce procédé à basse température garantit notamment les propriétés ultérieures des substrats protégés.

Les films déposés sont des polymères inorganiques et amorphes. Ils sont transparents et macroscopiquement continus, et d'une épaisseur de l'ordre du dizième de micromètre à quelques micromètres. La demanderesse a mis en évidence que la première couche, pour garantir les qualités d'adhésion du revêtement, a avantageusement une épaisseur comprise entre 1 et 30 nm, notamment entre 5 et 20 nm.

Les revêtements sont adhérents au substrat (test du papier adhésif) et résistants à l'abrasion. Les exemples ci-après décrivent les variations de température ainsi que les différents cycles thermiques que peuvent supporter les revêtements protégeant les substrats.

La demanderesse a mis en évidence que la présence de carbone dans le revêtement entraine une bonne résistance de celui-ci aux variations thermiques. Lorsque l'apport en carbone est réalisé par une source annexe, par exemple $CH_4$, le rapport Si/C provenant de cette source annexe est de préférence supérieur ou égal à 1.

Ces films ont en outre des propriétés de mouillabilité à l'eau en général supérieures à celles du substrat.

Outre ces propriétés, la demanderesse a mis en évidence que les revêtements selon l'invention ont des propriétés antistatiques. Cette propriété est intéressante pour les applications en micro-électronique où la présence de charges électrostatiques est particulièrement gênante : support de plaquette, support de circuits imprimés et de cartes, et en général tout moyen de stockage magnétique de l'information.

Les revêtements selon l'invention peuvent également conférer à la surface du substrat protégé des propriétés de dureté supérieures à celles du substrat.

De par leur dureté, ils présentent des avantages certains sur les dépôts organiques utilisés jusqu'alors pour la protection de support d'informations tels que les disques laser, bandes magnétiques et autres supports magnétiques.

Etant transparents, ces dépôts peuvent être utilisés pour la protection superficielle de toutes pièces transparentes particulièrement sensibles aux poussières et autres éléments retenus en surface par des charges électrostatiques.

Les applications ne sont pas limitées aux seuls objets en matières plastiques : la surface d'un objet en verre revêtu d'un tel dépôt devient également antistatique.

Le procédé selon l'invention assure une bonne qualité de la liaison surface-film dans des conditions normales ou agressives : adhérence, résistance aux bains chimiques, etc... Grâce aux propriétés optiques, mécaniques et chimiques du revêtement déposé (adhérence, dureté, résistance à l'abrasion, résistance chimique, etc...), celui-ci constitue une protection efficace des supports lors des agressions mécaniques ou chimiques, en particulier en ce qui concerne le maintien des qualités optiques (transmission élevée et diffusion faible).

Les substrats polymériques à protéger selon l'invention sont choisis particulièrement parmi les matériaux polymériques transparents moulés ou formés utilisés notamment comme glace dans les optiques de phares de véhicules. Il peut s'agir de matériaux du type polycarbonate en particulier, de polyméthylméthacrylate, de polystyrène acrylonitrile ou de polystyrène cristal.

Les polycarbonates sont des polymères par exemple du type poly-(oxycarbonyloxy-1,4-phénylène isopropylidène-1,4-phénylène) ou des copolymères à base de bisphénol A et d'un comonomère.

D'autres substrats peuvent cependant être protégés par un revêtement dur antistatique selon l'invention. On peut citer en particulier les polyamides, le PVC, les polyesters tel que le polyéthylènetéréphthalate; les polyimides, mais aussi le polycarbonate recouvert d'aluminium ainsi que les substrats en silicium.

De tels revêtements peuvent également être utiles sur du verre.

Les matériaux transparents peuvent être utilisés pour les vitrages et écrans, c'est à dire, outre pour les glaces de phare ou lentilles, notamment pour les visières de casque de moto, les carénages de moto, les vitres fixes ou mobiles, latérales ou toits ouvrants de véhicules et hublots d'avion, les optiques d'éclairage urbain et domestique, les vitrages de sécurité, les écrans et protections pour appareils et tableaux indicateurs, les serres, vérandas et toitures en plastique et les verres de montre ou de lunettes, organiques ou non, à titre d'exemples non limitatifs.

L'invention peut cependant également s'appliquer à la protection de matériaux non transparents, du fait que les revêtements présentent des propriétés antistatiques en particulier.

C'est pourquoi la présente invention concerne également l'application des revêtements selon l'invention à la protection des substrats contre les charges électrostatiques.

Le procédé selon l'invention peut être mis en oeuvre avec un dispositif tel qu'il est représenté à la figure unique.

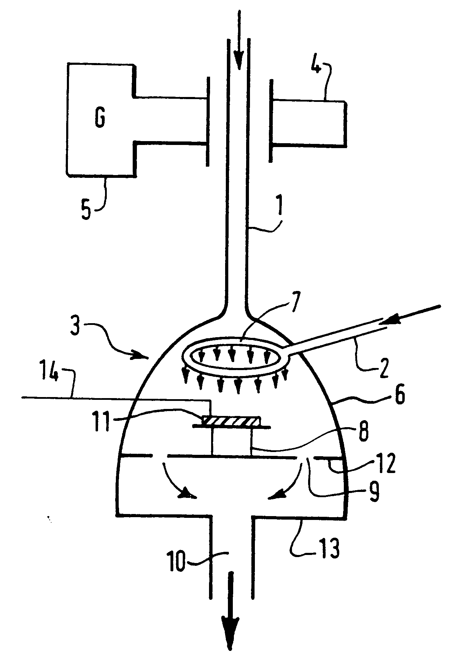

La figure 1 représente une coupe schématisée d'un mode de réalisation d'un dispositif pour la mise en oeuvre de procédé ci-dessus. L'enceinte 3 étanche est constituée d'une cloche 6 reposant sur une base circulaire 13. Une première voie d'injection 1 (voie 1), de même axe que la cloche 6 est reliée à au moins une source de gaz, non représentée. Cette voie d'injection 1 traverse un guide d'onde 4 relié à un générateur de micro-ondes 5. Une seconde voie d'injection 2 (voie 2) reliée à au moins une source de gaz, non représentée, traverse de façon étanche la paroi de la cloche 6 et est munie à son extrémité intérieure à la cloche 6 d'un répartiteur 7 du flux gazeux, de forme torique et muni d'orifices régulièrement espacés.

Le substrat 11 est placé sur un support 8 ; le support 8 comporte un plateau-support 12 muni d'orifices 9 symétriquement répartis. La base circulaire 13 de la cloche 6 comporte un orifice 10 d'évacuation des effluents de même axe que la cloche et relié à joint étanche à des moyens pour créer une dépression dans l'enceinte, non représentés. Il peut s'agir d'une pompe à vide par exemple. Un thermocouple 14 mesure la température à la surface de l'échantillon 11 et traverse la cloche à joint étanche.

La structure décrite ci-dessus permet de mettre en oeuvre le procédé de la façon suivante :

Comme cela apparaîtra dans les exemples, par la voie 1 pénètre un gaz plasmagène, qui reçoit l'énergie micro-onde du générateur G UHF par l'intermédiaire du guide d'onde 4. Des gaz précurseurs peuvent également être injectés par cette voie 1. La voie 2 et son répartiteur 7 permettent d'injecter le gaz précurseur du silicium, et éventuellement de l'hélium ou de l'argon.

Cependant la voie 2 peut également permettre l'injection de gaz plasmagène lorsque la voie 1 n'est empruntée que par un gaz précurseur. De préférence, le précurseur de silicium est injecté en post décharge par la voie 2.

La disposition axiale de la voie d'injection 1 et le répartiteur 7 de la voie d'injection 2 sont des moyens pour réaliser une injection homogène des gaz. De même, l'orifice 10, également axial et les orifices 9 du plateau 12 répartis symétriquement contribuent à l'homogénéité de l'évacuation des gaz. L'écoulement homogène des gaz conditionne l'homogénéité du dépôt sur le substrat 11 placé au centre des flux ainsi créés.

D'autres variantes non représentées, par exemple où la symétrie ne serait pas cylindrique, ou encore où les voies d'injection seraient multipliées, sont également envisageables, leur disposition devant tenir compte de la forme, de la taille et du nombre des substrats à traiter, dans le souci d'une homogénéité des flux gazeux, qui détermine l'homogénéité du dépôt.

Les moyens de dépression non représentés à l'extérieur du dispositif, à l'extrémité de l'orifice 10 permettent de réguler la pression en fonction des débits gazeux.

L'invention sera mieux comprise à la lecture des exemples de réalisation ci-après.

**Exemple 1 :**

Un dépôt est réalisé selon le procédé sur un morceau de polycarbonate de 5 x 2 cm selon la séquence suivante :

1) prétraitement plasma Ar puis plasma Ar contenant 10 % de $NH_3$

2) dépôt par plasma pendant 1 minute d'une couche de composition $Si\ C_{0,5}\ N_{0,15}\ O_{0,8}\ H$ à partir de la phase gazeuse suivante :

$Si\ H_4$ = 0,7 % ; He = 22,6 % ; Ar = 76,7%. (pression 0;15 $10^2$ Pa; G générateur à plasma micro-onde = 2,45 GHz ; P = 60W)

3) dépôt par plasma pendant 1 heure d'une couche d'épaisseur 1,5 µm et de composition $Si\ C_{0,5}\ N_{0,8}\ O_2\ H$ à partir d'une phase gazeuse de composition $SiH_4$ = 0,6 % ; Ar = 69 % ; He = 20,4% ; $N_2$ = 10 % . (pression 0,5 $10^2$ Pa ; G générateur à plasma micro-onde = 2,45 GHz ; P = 60W)

Le polycarbonate revêtu du dépôt est ensuite introduit dans une enceinte thermique maintenue à + 25°C et le cycle thermique tel que défini ci-dessous est réalisé :

– 16h à + 25°C

– descente de + 25°C à - 25°C à 0,6°C/min.

– 1h à - 25°C

– chauffage de - 25°C à + 80°C à 1°C/min.

– 1h à + 80°C

– retour à + 25°C.

L'échantillon ne subit aucune altération.

Ce même échantillon est donc introduit dans une enceinte thermique contenant 100 % d'humidité relative (100 % HR).

Le cycle thermique suivant est donc réalisé.

– 16h à + 25°C
– descente de + 25°C à - 25°C à 0,6°C/min.
– 1h à - 25°C
– chauffage de - 25°C à + 80°C à 1°C/min.
– 1h à + 80°C
– retour à + 25°C.

Après deux cycles thermiques, l'échantillon est retiré et examiné : aucune altération visible n'est observable.

**Exemple 2 :**

L'échantillon de polycarbonate est remplacé par un échantillon de polyimide KAPTON (Dupont de Nemours) de 125 $\mu$m d'épaisseur. Un dépôt tel que décrit dans l'exemple 1 est réalisé.

L'échantillon subit sans aucune altération 10 cycles thermiques ainsi que plus de 5 cycles thermiques à 100 % HR.

De plus, le substrat de 125 $\mu$m revêtu du dépôt garde toute sa souplesse et peut être déformé sans qu'aucune fissure ni aucune altération n'apparaisse sur le dépôt.

**Exemple 3 :**

Un dépôt est réalisé selon le procédé sur un échantillon de polycarbonate de 5 x 2 cm selon la séquence suivante :

1) prétraitement plasma Ar puis plasma Ar contenant 10 % de $NH_3$.
2) dépôt par plasma pendant une minute à partir de la phase gazeuse suivante :
$Si_2 H_6$ = 0,35 % ; He = 22,95 % ; et Ar = 76,7 %
(générateur plasma micro-onde G à 2,45 GHz puissance : 60W; pression : 0,17 $10^2$ Pa.)
3) dépôt par plasma pendant une heure d'une couche d'épaisseur 1,25 $\mu$m à partir de la phase gazeuse suivante : $Si_2 H_6$ = 0,3 % ; $H_e$ = 20,7 % $N_2$ = 10 % ; Ar = 69 %.
(générateur plasma micro-onde G à 2,45 GHz, puissance 60 - 70 W, pression : 0,36 $10^2$ Pa.)
Le dépôt obtenu est transparent et parfaitement adhérent au polycarbonate.

**Revendications**

1. Revêtement multicouche pour substrat, comportant essentiellement du silicium, du carbone, de l'azote, de l'oxygène et de l'hydrogène, constitué d'au moins deux couches, la première couche déposée sur le substrat ayant pour formule $Si C_x N_y O_z H_t$, où x = 0 - 0,5 ; y = 0 - 0,15 ; z = 0,4 - 1 et t = 0,6 - 1,2 .

2. Revêtement selon la revendication **1, caractérisé en ce que** z = 0,6 - 0,8.

3. Revêtement selon la revendication **2, caractérisé en ce qu'**elle comporte une seconde couche déposée sur le première couche de formule $Si C_x N_y O_z H_t$, où x' = 0 - 5 ; y' = 0,3 - 0,8 ; z' = 1,3 - 2,5 et t' = 0,5 - 1,2 ; notamment x' = 0,3 - 1 ; y' = 0,5 - 0,8; z' = 1,3 - 2 ; t' = 0,6 - 1.

4. Revêtement selon la revendication **1, 2 ou 3, caractérisé en ce que** l'épaisseur de la première couche est comprise entre 1 et 30 nm, notamment entre 5 à 20 nm.

5. Procédé de protection de substrat par dépôt d'un revêtement multicouche comportant essentiellement du silicium, du carbone, de l'azote, de l'oxygène et de l'hydrogène, **caractérisé en ce qu'**il comporte au moins le étapes suivantes :
– on soumet le substrat à un pré-traitement par plasma micro-onde ;
– on expose la surface du substrat prétraité à un plasma micro-onde en présence de précurseur gazeux de silicium pour déposer une première couche ; et
– on soumet le substrat muni de la première couche à un plasma micro-onde en présence des précurseurs gazeux de silicium et d'azote dans le plasma ou en post-décharge pour déposer une seconde couche.

6. Procédé selon la revendication **5, caractérisé en ce que** le le prétraitement est réalisé avec un plasma $O_2$ ou $NH_3$.

7. Procédé selon la revendication **5 ou 6, caractérisé en ce que** le précurseur d'azote est choisi parmi l'azote et l'ammoniac.

8. Procédé selon l'une des revendications **5 à 7, caractérisé en ce que** lors du dépôt de la seconde couche, on introduit en outre $O_2$;$N_2O$; $CH_4$ ; $CO_2$ ou $C_2 H_4$ dans le plasma ou en post- décharge.

9. Procédé selon l'une des revendications **5 à 8, caractérisé en ce que** le précurseur de silicium est un silane, notamment $SiH_4$, $Si_2 H_6$ ou $Si_3 H_8$.

10. Procédé selon l'une des revendications **5 à 9, caractérisé en ce que** le substrat est polymérique du type polycarbonate, polyméthylméthacrylate, polystyrène-acrylonitrile ou polystyrène cristal, polyimide, polyester, polyamide, chlorure de polyvinyle, ou du verre, du silicium ou de l'aluminium.

11. Procédé selon l'une des revendications **5 à 10, caractérisé en ce que** la pression est inférieure à environ 13,3.$10^2$ Pa, en particulier inférieure à environ 0, 665. $10^2$ Pa.

12. Application des revêtements selon les revendications **1, 2, 3 ou 4** à la protection de vitrages et écrans, notamment pour les glaces de phares ou lentilles et les verres de lunettes.

13. Application des revêtements selon les revendications **1, 2, 3 ou 4** à la protection des substrats contre les charges électrostatiques.

**Patentansprüche**

1. Mehrschichtiger Überzug für ein Substrat, der im wesentlichen Silicium, Kohlenstoff, Stickstoff, Sauerstoff und Wasserstoff umfaßt und aus wenigstens zwei Schichten besteht, wobei die erste auf dem Substrat aufgebrachte Schicht die Formel $SiC_xN_yO_zH_t$ hat, worin $x = 0$ bis $0,5$, $Y = 0$ bis $0,15$, $z = 0,4$ bis $1$ und $t = 0,6$ bis $1,2$.

2. Überzug nach Anspruch 1, **dadurch gekennzeichnet,** daß $z = 0,6$ bis $0,8$.

3. Überzug nach Anspruch 1, **dadurch gekennzeichnet,** daß er eine auf der ersten Schicht aufgebrachte zweite Schicht der Formel $SiC_{x'}N_{y'}O_{z'}H_{t'}$ umfaßt, worin $x' = 0$ bis $5$, $y' = 0,3$ bis $0,8$, $z' = 1,3$ bis $2,5$ und $t' = 0,5$ bis $1,2$, insbesondere $x' = 0,3$ bis $1$, $y' = 0,5$ bis $0,8$, $z' = 1,3$ bis $2$, $t' = 0,6$ bis $1$.

4. Überzug nach Anspruch 1, 2 oder 3, **dadurch gekennzeichnet,** daß die Dicke der ersten Schicht zwischen 1 und 30 nm, insbesondere zwischen 5 und 20 nm liegt.

5. Verfahren zum Schutz eines Substrates durch Aufbringung eines mehrschichtigen Überzuges, der im wesentlichen Silicium, Kohlenstoff, Stickstoff, Sauerstoff und Wasserstoff umfaßt, **dadurch gekennzeichnet**, daß es wenigstens die folgenden Stufen umfaßt, in denen man

– das Substrat einer Vorbehandlung durch Mikrowellenplasma unterwirft,

– die mit einem Mikrowellenplasma vorbehandelte Substratoberfläche einem gasförmigen Siliciumvorlaufer zur Ablagerung einer ersten Schicht aussetzt und

– das mit der ersten Schicht versehene Substrat einem Mikrowellenplasma in Gegenwart gasförmiger Vorlaufer von Silicium und Stickstoff in dem Plasma oder bei Nachentladung ausssetzt, um eine zweite Schicht abzulagern.

6. Verfahren nach Anspruch 5, **dadurch gekennzeichnet,** daß die Vorbehandlung mit einem $O_2$- oder $NH_3$-Plasma durchgeführt wird.

7. Verfahren nach Anspruch 5 oder 6, **dadurch gekennzeichnet**, daß der Stickstofforläufer unter Stickstoff und Ammoniak ausgewählt wird.

8. Verfahren nach einem der Ansprüche 5 bis 7, **dadurch gekennzeichnet**, daß man während der Ablagerung der zweiten Schicht außerdem $O_2$, $N_2O$, $CH_4$, $CO_2$ oder $C_2H_4$ in das Plasma oder bei Nachentladung einführt.

9. Verfahren nach einem der Ansprüche 5 bis 8, **dadurch gekennzeichnet,** daß der Siliciumvorläufer ein Silan, insbesondere $SiH_4$, $Si_2H_6$ oder $Si_3H_6$ ist.

10. Verfahren nach einem der Ansprüche 5 bis 9, **dadurch gekennzeichnet**, daß das Substrat polymer vom Typ Polycarbonat, Polymethylmethacrylat, Polystyrol-Acrylnitril oder Polystyrolkristall, Polyimid, Polyester, Polyamid oder Polyvinylchlorid ist oder aus Glas, Silicium oder Aluminium besteht.

11. Verfahren nach einem der Ansprüche 5 bis 10, **dadurch gekennzeichnet,** daß der Druck unter etwa $13,3 \times 10^2$ Pa, insbesondere unter etwa $0,665 \times 10^2$ Pa liegt.

12. Verwendung von Überzügen nach den Ansprüchen 1, 2, 3 oder 4 zum Schutz von Gläsern und Abschirmungen, insbesondere für Scheinwerferscheiben oder Linsen und Brillenglaser.

13. Verwendung von Überzügen nach den Ansprüchen 1, 2, 3 oder 4 zum Schutz von Substraten gegen elektrostatische Ladungen.

**Claims**

1. Multilayer coating for a substrate, which multilayer coasting essentially comprises silicon, carbon, nitrogen, oxygen and hydrogen, and is formed by at least two layers, the first layer deposited on the substrate having the formula $Si\, C_x\, N_y\, O_z\, H_t$, in which $x = 0 - 0.5$; $y = 0 - 0.15$; $z = 0.4 - 1$ and $t = 0.6 - 1.2$.

2. Coating according to claim 1, **characterised in that** $z = 0.6 - 0.8$.

3. Coating according to claim 2, **characterised in that** it comprises a second layer deposited on the first layer having the formula $Si\, C_x\, N_y\, O_z\, H_t$, in which $x' = 0 - 5$; $y' = 0.3 - 0.8$; $z' = 1.3 - 2.5$ and $t' = 0.5 - 1.2$; in particular $x' = 0.3 - 1$; $y' = 0.5 - 0.8$; $z' = 1.3 - 2$; $t' = 0.6 - 1$.

4. Coating according to claim 1, 2 or 3, **characterised in that** the thickness of the first layer is between 1 and 30 nm, in particular between 5 and 20 nm.

5. Process for the protection of a substrate by depositing a multilayer coating essentially comprising silicon, carbon, nitrogen, oxygen and hydrogen, **characterised in that** it comprises at least the following steps:

– the substrate is subjected to a pretreatment by microwave plasma;

– the surface of the pretreated substrate is exposed to a microwave plasma in the presence of a gaseous precursor of silicon in order to deposit a first layer; and

– the substrate, which is provided with the first layer, is subjected to a microwave plasma in the presence of the gaseous precursors of silicon and nitrogen in plasma or in afterglow for depositing a second layer.

6. Process according to claim 5, **characterised in that** the pretreatment is carried out with an $O_2$ or $NH_3$ plasma.

7. Process according to claim 5 or 6, **characterised in that** the precursor of nitrogen is chosen from nitrogen and ammonia.

8. Process according to one of claims 5 to 7, **characterised in that,** during the depositing of the second layer, $O_2$; $N_2O$; $CH_4$; $CO_2$ or $C_2\, H_4$ is also intro-

duced into the plasma or in afterglow.

9. Process according to one of claims 5 to 8, **characterised in that** the precursor of silicon is a silane, in particular $SiH_4$, $Si_2 H_6$ or $Si_3 H_8$.

10. Process according to one of claims 5 to 9, **characterised in that** the substrate is polymeric of the polycarbonate, polymethylmethacrylate, polystyrene-acrylonitrile or crystal polystyrene, polyimide, polyester, polyamide, polyvinyl chloride type, or glass, silicon or aluminium.

11. Process according to one of claims 5 to 10, **characterised in that** the pressure is less than approximately $13.3 . 10^2$ Pa, in particular less than approximately $0.665 . 10^2$ Pa.

12. Application of the coatings according to claim 1, 2, 3 or 4 to the protection of glazing and screens, in particular for the glass of headlamps or lenses and the glass lenses of spectacles.

13. Application of the coatings according to claim 1, 2, 3 or 4 to the protection of substrates against electrostatic charges.